# EUROPEAN PATENT APPLICATION

(11) **EP 4 393 674 A1**
(43) Date of publication of application: **03.07.2024**
(21) Application number: 23169712.9
(22) Date of filing: 25.04.2023
(51) Int. Cl.: B29C 45/00, B29C 69/00, H05K 5/02, B29C 45/14

(54) **MANUFACTURING PROCESS OF NOVEL LIGHT-WEIGHT VACUUM THERMAL INSULATION MODULE, AND VACUUM THERMAL INSULATION MODULE**

(30) Priority: 26.12.2022 CN 202211674690
(71) Applicant: Dongguan HongYi Electronics Co., Ltd, Dongguan City, Guangdong (CN)
(72) Inventor: HU, Meng, Zhangjiajie City (CN); CHEN, Jiliang, Dongguan City (CN)
(74) Representative: Sach, Greg Robert

(57) **Abstract**

The present disclosure relates to the technical field of thermal insulation modules, in particular to a manufacturing process of a novel light-weight vacuum thermal insulation module, and a vacuum thermal insulation module. The manufacturing process includes the following steps: step 1, preparation: selecting a macromolecular polymer as a wall material of the vacuum thermal insulation module, the macromolecular polymer being prepared by mixing polyether-ether-ketone, high-temperature nylon, a liquid crystal macromolecular polymer and polyphenylene sulfide, and stirring the macromolecular polymer with a heating and stirring hopper to achieve a liquid state. The macromolecular polymer is selected as the wall material of a cavity, which has a low heat conductivity, so that a local high temperature in junctions is avoided. Based on the advantages of injection molding, the cavity can be almost perfectly molded by means of an injection molding process, thus reducing the area of a connection plane.

## Description

### TECHNICAL FIELD

The present disclosure relates to the technical field of thermal insulation modules, in particular to a manufacturing process of a novel light-weight vacuum thermal insulation module, and a vacuum thermal insulation module.

### BACKGROUND

Temperature control of an electronic product has a key impact on the service life and touch experience of the electronic product. At present, a traditional temperature control means is to quickly export heat inside the electronic product to an outer shell, so as to achieve the purpose of cooling. However, in many cases, this may lead to an extremely high local temperature of the outer shell, which will affect the product experience. In some scenarios where a low outer shell temperature and a high inner shell temperature are required, the above method cannot be used to control the temperature.

A traditional method for preventing an extremely high local temperature of an outer shell is mainly implemented by a thermal insulation module. A thermal insulation module is arranged between a housing and a heat source. The thermal insulation module generally includes an attachable aerogel thermal insulation layer, low thermal conductivity thermal insulation foam and other materials to increase a heat transfer resistance between the heat source and the outer shell. However, these materials have limited temperature resistance. When the temperature rises, the adhesive force of an adhesive layer will decline, causing the materials to fall off or slide. Moreover, the thermal insulation performance of the material itself will decline as the temperature rises. At the same time, the traditional thermal insulation materials such as the aerogel thermal insulation layer and the thermal insulation foam have outstanding characteristics of low mechanical strength and lack of self-supporting. They need to be adhered to some structural plates with strength such as plastic, ceramic or metal. In order to facilitate the adhesion, the surfaces of these plates are always required to be flat. The thermal conductivity of these plates is much higher than that of a thermal insulation material, which affects the overall thermal insulation effect. Their surfaces are required to be flat, which also restrains the application range of these materials, or brings great impact on the structural design of products.

The thermal insulation module also has a vacuum thermal insulation structure, but the traditional vacuum thermal insulation module is usually welded by stainless steel, aluminum alloy, copper alloy and other metals. Metal has high thermal conductivity. A vacuum cavity blocks the heat transfer in a thickness direction, and the heat is guided to a cavity junction, causing a local high-temperature point. A thermal insulation pipe made of a metal base material has a large density and is heavy, so that it is inconvenient to use in portable equipment and aircrafts. After the traditional metal vacuum thermal insulation module is used for many times, the performance will decline rapidly in high-temperature and high-humidity scenarios due to corrosion and leakage at a sealing port. In addition, it is of great difficulty in forming a metal cavity. There are many junctions, leading to high leakage risk. This is also an important reason of the decline of the performance of the metal thermal insulation module.

### SUMMARY

In order to overcome the above deficiencies, the present disclosure aims to provide a technical solution capable of solving the above problems.

A manufacturing process of a novel light-weight vacuum thermal insulation module includes the following steps:
step 1, preparation: selecting a macromolecular polymer as a wall material of the vacuum thermal insulation module, the macromolecular polymer being prepared by mixing polyether-ether-ketone, high-temperature nylon, a liquid crystal macromolecular polymer and polyphenylene sulfide, and stirring the macromolecular polymer with a heating and stirring hopper to achieve a liquid state;
step 2, molding: performing injection molding on the liquid-state macromolecular polymer by adopting an injection molding process to obtain a first wall surface and a second wall surface, the first wall surface and the second wall surface having mutually butted encapsulation surfaces, and forming a cavity between the first wall surface and the second wall surface after the encapsulated surfaces of the first wall surface and the second wall surface are butted;
step 3, setting of a getter: putting a getter into the cavity to further increase the vacuum degree of the final cavity and improve the thermal insulation efficiency;
step 4, vacuumizing by a vacuum pump: controlling an air extraction end of the vacuum pump to extend into the cavity along the encapsulation surfaces of the first wall surface and the second wall surface, the air extraction end being of a flat structure and overcoming, in a state of encapsulating and closing the first wall surface and the second wall surface, the stress of the macromolecular polymer material to enter the cavity to vacuumize the cavity; and
step 5, encapsulation: combining the encapsulation surfaces of the first wall surface and the second wall surface while vacuumizing, wherein the combination and the vacuumizing are synchronously performed; portions, not corresponding to the air extraction end of the vacuum pump, between the first wall surface and the second wall surface are first combined; the air extraction end is pulled out after the vacuumizing is completed, and under the action of an external atmospheric pressure, the first wall surface and the second wall surface promote portions, butted with the air extraction end, on the encapsulation surfaces to be closed; and the positions are then combined to form a vacuum thermal insulation module finished product.

Preferably, the first wall surface is of an enclosed structure with a gap; the cavity is formed in the first wall surface; the second wall surface is of a sheet structure; the second wall surface is in encapsulation fit with the gap; and a position of the first wall surface located around the gap and a portion of the second wall surface corresponding to the position are used as the encapsulation surfaces.

Preferably, after the getter is put in, the wall surface in the cavity is braced; and the cavity is filled with a low thermal conductivity multiporous core material to avoid collapse deformation of the material in the vacuumizing process.

Preferably, the injection molding process of the first wall surface adopts a rubber coating injection molding process; during injection molding, the multiporous core material embedded with the getter is put into a mold, and rubber coating injection molding is performed on a surface of the multiporous core material; and after molding, the multiporous core material and the getter are directly located in the cavity.

Preferably, after the first wall surface and the second wall surface have been subjected to injection molding, a polishing and coating process is performed on the first wall surface and the second wall surface: outer surfaces of the first wall surface and the second wall surface are polished, and the surfaces of the first wall surface and the second wall surface are coated with at least one layer of reflecting film.

Preferably, the encapsulation surfaces of the first wall surface and the second wall surface are combined by an adhesion process; all adhesion surfaces are smeared with an adhesive; in the process, the vacuum pump is used to vacuumize the sealed cavity formed by the first wall surface and the second wall surface; and the air extraction end is pulled out after the adhesive is cured, thus preparing a vacuum thermal insulation module finished product.

Preferably, the encapsulation surfaces of the first wall surface and the second wall surface are combined by a fusion process; a fixing jig with a heating structure is configured to locate and place the first wall surface and the second wall surface, so that the encapsulation surfaces of the first wall surface and the second wall surface are located at the heating structure, and fusion surfaces are formed on the encapsulation surfaces of the first wall surface and the second wall surface to achieve high-temperature molten fusion; in the fusion process, the vacuum pump is used to vacuumize the cavity formed between the first wall surface and the second wall surface; the fusion adhesion rate is controlled to be matched with the vacuumizing rate to ensure that fusion and vacuumizing end at the same time, thus preparing a vacuum thermal insulation module finished product.

Preferably, the encapsulation surfaces of the first wall surface and the second wall surface are combined by an ultrasonic welding process; ultrasonic waves are applied to part of the encapsulation surfaces of the first wall surface and the second wall surface; in the process, the vacuum pump is used to vacuumize the cavity formed between the first wall surface and the second wall surface; the ultrasonic welding rate is controlled to be matched with the vacuumizing rate to ensure that fusion and vacuumizing end at the same time, thus preparing a vacuum thermal insulation module finished product.

A novel light-weight vacuum thermal insulation module is provided, which adopts the vacuum thermal insulation module manufactured by the manufacturing process of a novel light-weight vacuum thermal insulation module, wherein the novel light-weight vacuum thermal insulation module includes a first wall surface and a second wall surface; the first wall surface is of an enclosed structure with a gap, and the second wall surface is of a sheet structure; the second wall surface is in encapsulation fit with the gap, so that a vacuum cavity is formed between the first wall surface and the second wall surface; a position of the first wall surface located around the gap and a portion of the second wall surface corresponding to the position are provided with encapsulation surfaces; the first wall surface and the second wall surface are sealed by the encapsulation surfaces; and the cavity is internally provided with a getter and is filled with a multiporous core material.

Preferably, one smooth layer is arranged on outer surfaces of the first wall surface and the second wall surface; a layer of reflecting film is attached to the smooth layer; and one of an adhesive, a fusion surface or an ultrasonic welding surface is arranged between the encapsulation surfaces of the first wall surface and the second wall surface.

Compared with the prior art, the present disclosure has the beneficial effects below:

The macromolecular polymer is selected as the wall material of the cavity, which has low thermal conductivity, so that a local high temperature in junctions is avoided. This is the main defect of a traditional metal vacuum tube at present.

The wall material is injection-molded. Based on the advantages of injection molding, the cavity can be almost perfectly molded by means of an injection molding process, thus reducing the area of a connection plane.

The macromolecular polymer is selected as the wall material, which has a low density and is a novel light-weight thermal insulation module lighter than the traditional metal vacuum thermal insulation module by 80%.

The macromolecular polymer is selected as the wall material, which has high chemical stability. It is a thermal insulation module with perfect environmental adaptability that is much greater than that of the traditional metal vacuum thermal insulation module.

The additional aspects and advantages of the prevent disclosure will be provided in the following descriptions, part of which will become apparent from the following descriptions or be learned through the practice of the prevent disclosure.

### BRIEF DESCRIPTION OF THE DRAWINGS

To describe the embodiments of the present disclosure or the technical solutions in the existing art more clearly, drawings required to be used in the embodiments or the illustration of the existing art will be briefly introduced below. Obviously, the drawings in the illustration below are only some embodiments of the present disclosure. Those ordinarily skilled in the art also can acquire other drawings according to the provided drawings without doing creative work.
FIG. 1 is a flow chart of a process of the present disclosure;
FIG. 2 is a schematic structural diagram of the present disclosure;
FIG. 3 is a schematic sectional structural diagram of the present disclosure;
FIG. 4 is a schematic structural diagram of a reflecting film of the present disclosure;
FIG. 5 is a schematic structural diagram of a thermal insulation layer of the present disclosure; and
FIG. 6 is a schematic structural diagram of cooperation between a cylindrical, square or vacuum plate type vacuum thermal insulation module and a heat source.

Reference signs and names in the drawings are as follows:
wall material 10, first wall surface 11, second wall surface 12, cavity 13, encapsulation surface 14, multiporous core material 15, smooth layer 16, reflecting film 17, thermal insulation layer 18, gap 19, and heat source 20.

### DETAILED DESCRIPTION OF THE EMBODIMENTS

The technical solutions in the embodiments of the present disclosure will be clearly and completely described below. Apparently, the described embodiments are only a part of the embodiments of the present disclosure, rather than all the embodiments. All other embodiments obtained by those of ordinary skill in the art based on the embodiments in the present disclosure without creative work shall fall within the protection scope of the present disclosure.

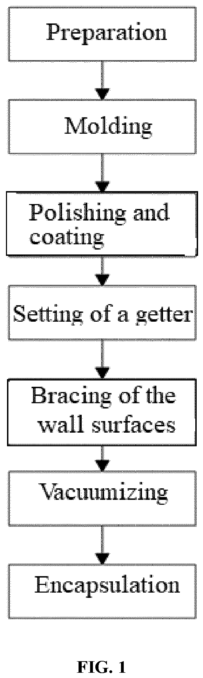

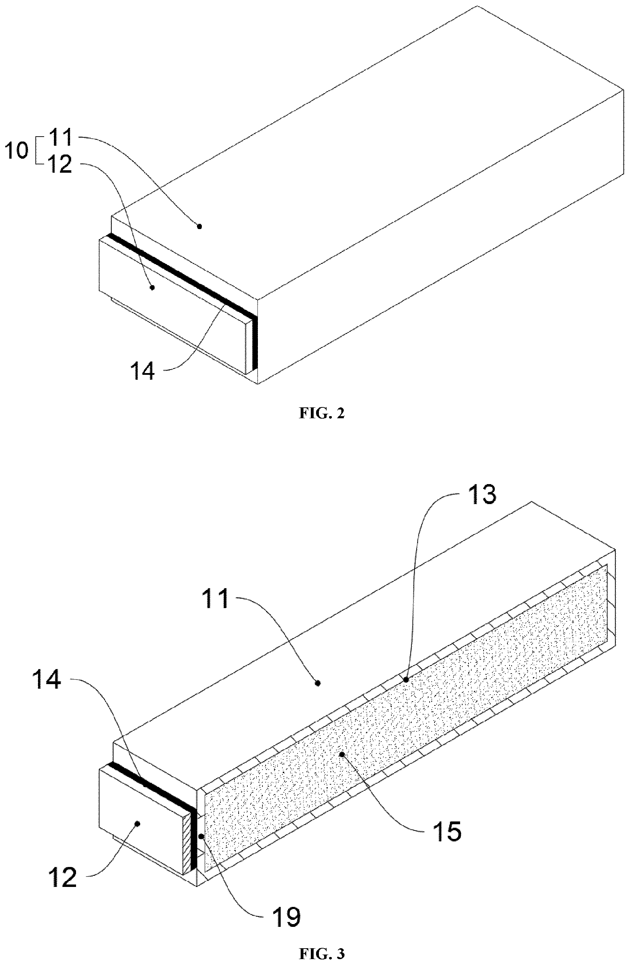

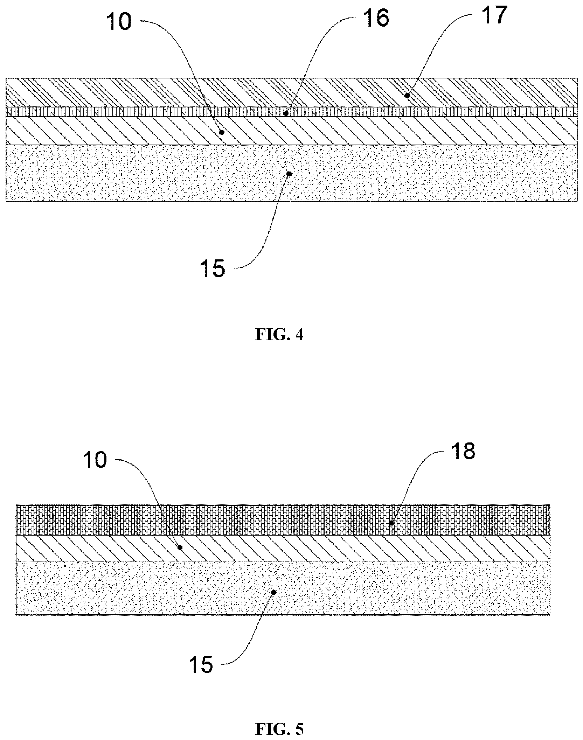

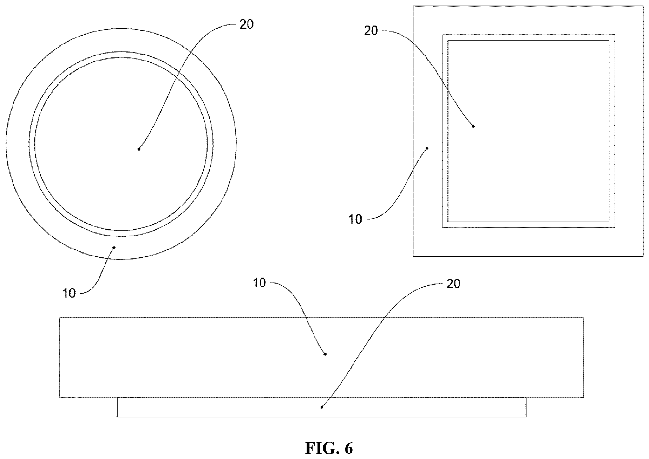

Referring to FIG. 1 to FIG. 6, in the embodiments of the present disclosure, a manufacturing process of a novel light-weight vacuum thermal insulation module includes the following steps:
step 1, preparation: selecting a macromolecular polymer as a wall material 10 of the vacuum thermal insulation module, the macromolecular polymer being prepared by mixing polyether-ether-ketone, high-temperature nylon, a liquid crystal macromolecular polymer and polyphenylene sulfide, and stirring the macromolecular polymer with a heating and stirring hopper to achieve a liquid state;
step 2, molding: performing injection molding on the liquid-state macromolecular polymer by adopting an injection molding process to obtain a first wall surface 11 and a second wall surface 12, the first wall surface 11 and the second wall surface 12 having mutually butted encapsulation surfaces 14, and forming a cavity 13 between the first wall surface 11 and the second wall surface 12 after the encapsulated surfaces 14 of the first wall surface 11 and the second wall surface 12 are butted;
step 3, setting of a getter: putting a getter into the cavity 13 to further increase the vacuum degree of the final cavity 13 and improve the thermal insulation efficiency;
step 4, bracing of the wall surfaces: filling the cavity 13 with a low thermal conductivity multiporous core material 15 to avoid collapse deformation of the material in the vacuumizing process;
step 5, vacuumizing by a vacuum pump: controlling an air extraction end of the vacuum pump to extend into the cavity 13 along the encapsulation surfaces 14 of the first wall surface 11 and the second wall surface 12, the air extraction end being of a flat structure and overcoming, in a state of encapsulating and closing the first wall surface 11 and the second wall surface 12, the stress of the macromolecular polymer material to enter the cavity 13 to vacuumize the cavity 13; and
step 6, encapsulation: combining the encapsulation surfaces 14 of the first wall surface 11 and the second wall surface 12 while vacuumizing, wherein the combination and the vacuumizing are synchronously performed; portions, not corresponding to the air extraction end of the vacuum pump, between the first wall surface 11 and the second wall surface 12 are first combined; the air extraction end is pulled out after the vacuumizing is completed, and under the action of an external atmospheric pressure, the first wall surface 11 and the second wall surface 12 promote portions, butted with the air extraction end, on the encapsulation surfaces 14 to be closed; and the positions are then combined to form a vacuum thermal insulation module finished product.

In the vacuum thermal insulation module of the present disclosure, the first wall surface 11 faces one side of a heat source 20, and the second wall surface 12 faces an external side. An attachable thermal insulation layer 18 further improves the thermal insulation effect. The vacuum thermal insulation module can be of a cylindrical, square or polygonal sleeve structure or a vacuum plate type structure.

Compared with a traditional aerogel thermal insulation layer 18, polyurethane foam, etc., this vacuum thermal insulation module has better thermal insulation performance. The equivalent thermal conductivity of the traditional thermal insulation material in a thickness direction is about 0.02 W/m.K, and the equivalent thermal conductivity of the vacuum thermal insulation module of the present disclosure in the thickness direction is as low as 0.002 W/m.K, and has structural strength, so that it can be used in equipment as a structural support.

Compared with the traditional vacuum thermal insulation module, the macromolecular polymer material itself has low thermal conductivity, which can avoid local high temperature points injunctions and solve the main defect of the current traditional metal vacuum tube.

Compared with the traditional vacuum thermal insulation module, the vacuum thermal insulation module of the present disclosure has a lower material density (the density of stainless steel is 7.7 g/cm3, and the density of the macromolecular material used in the present disclosure is less than 1.5 g/cm3). The novel light-weight thermal insulation module is lighter than the traditional metal vacuum thermal insulation module by 80%, and the weight of a thermal insulation plate/tube is lighter, which has obvious advantages in applications to portable mobile equipment and aircrafts.

The wall material 10 is injection-molded. Based on the advantages of injection molding, the cavity can be almost perfectly molded by means of an injection molding process. The first wall surface 11 is of an enclosed structure with a gap 19. The cavity 13 is formed in the first wall surface 11. The second wall surface 12 is of a sheet structure. The second wall surface 12 is in encapsulation fit with the gap 19. A position of the first wall surface 11 located around the gap 19 and a portion of the second wall surface 12 corresponding to the position are used as the encapsulation surfaces 14. Thus, a connection area of the first wall surface 11 and the second wall surface 12 is greatly reduced. Compared with the traditional vacuum thermal insulation module which adopts a metal wall material 10 and can only use a welding process, the present disclosure introduces the injection molding process for the macromolecular polymer wall material 10. Due to the use of a connection plane, sealed connection planes can be reduced, and the thermal insulation durability of the module can be improved.

Compared with the traditional vacuum thermal insulation module, the present disclosure has the advantage that the macromolecular polymer material has high chemical stability, so that the thermal insulation module has perfect environmental adaptability that is much greater than that of the traditional metal vacuum thermal insulation module. The corrosion effect can be reduced, and the environmental adaptability is higher.

In order to improve the efficiency of step 2, step 4 and step 5, in combination with lowering the requirement for significant size reduction of the encapsulation surfaces 14 of the first wall surface 11 and the second wall surface 12, the injection molding process of the first wall surface 11 adopts a rubber coating injection molding process. During injection molding, the multiporous core material 15 embedded with the getter is put into a mold, and rubber coating injection molding is performed on a surface of the multiporous core material 15. After molding, the multiporous core material 15 and the getter are directly located in the cavity 13.

After the first wall surface 11 and the second wall surface 12 have been subjected to injection molding, a polishing and coating process is performed on the first wall surface 11 and the second wall surface 12: outer surfaces of the first wall surface 11 and the second wall surface 12 are polished, and the surfaces of the first wall surface 11 and the second wall surface 12 are coated with at least one layer of reflecting film 17. Thus, a heat reflection effect can be achieved, and the thermal insulation intensity is further enhanced.

The combination of the encapsulation surfaces 14 of the first wall surface 11 and the second wall surface 12 adopts the following three embodiments:
Embodiment 1: The encapsulation surfaces 14 of the first wall surface 11 and the second wall surface 12 are combined by an adhesion process. All adhesion surfaces are smeared with an adhesive. In the process, the vacuum pump is used to vacuumize the sealed cavity 13 formed by the first wall surface 11 and the second wall surface 12. The air extraction end is pulled out after the adhesive is cured, thus preparing a vacuum thermal insulation module finished product.
Embodiment 2: The encapsulation surfaces 14 of the first wall surface 11 and the second wall surface 12 are combined by a fusion process. A fixing jig with a heating structure is configured to locate and place the first wall surface 11 and the second wall surface 12, so that the encapsulation surfaces 14 of the first wall surface 11 and the second wall surface 12 are located at the heating structure, and fusion surfaces are formed on the encapsulation surfaces 14 of the first wall surface 11 and the second wall surface 12 to achieve high-temperature molten fusion. In the fusion process, the vacuum pump is used to vacuumize the cavity 13 formed between the first wall surface 11 and the second wall surface 12. The fusion adhesion rate is controlled to be matched with the vacuumizing rate to ensure that fusion and vacuumizing end at the same time, thus preparing a vacuum thermal insulation module finished product.
Embodiment 3: The encapsulation surfaces 14 of the first wall surface 11 and the second wall surface 12 are combined by an ultrasonic welding process. Ultrasonic waves are applied to part of the encapsulation surfaces 14 of the first wall surface 11 and the second wall surface 12. In the process, the vacuum pump is used to vacuumize the cavity 13 formed between the first wall surface 11 and the second wall surface 12. The ultrasonic welding rate is controlled to be matched with the vacuumizing rate to ensure that fusion and vacuumizing end at the same time, thus preparing a vacuum thermal insulation module finished product.

A vacuum thermal insulation module manufactured by the above manufacturing process of a novel light-weight vacuum thermal insulation module mainly includes a first wall surface 11 and a second wall surface 12. The first wall surface 11 is of an enclosed structure with a gap 19, and the second wall surface 12 is of a sheet structure. The second wall surface 12 is in encapsulation fit with the gap 19, so that a vacuum cavity 13 is formed between the first wall surface 11 and the second wall surface 12. A position of the first wall surface 11 located around the gap 19 and a portion of the second wall surface 12 corresponding to the position are provided with encapsulation surfaces 14. The first wall surface 11 and the second wall surface 12 are sealed by the encapsulation surfaces 14. The cavity 13 is internally provided with a getter and is filled with a multiporous core material 15. One smooth layer 16 is arranged on outer surfaces of the first wall surface 11 and the second wall surface 12. A layer of reflecting film 17 is attached to the smooth layer 16. One thermal insulation layer 18 is also arranged on the outer surfaces of the first wall surface 11 and the second wall surface 12. One of an adhesive, a fusion surface or an ultrasonic welding surface is arranged between the encapsulation surfaces 14 of the first wall surface 11 and the second wall surface 12.

For those skilled in the art, it is apparent that the present disclosure is not limited to the details of the demonstrative embodiments mentioned above, and that the present disclosure can be realized in other specific forms without departing from the spirit or basic features of the present disclosure. Therefore, from any point of view, the embodiments should be regarded as exemplary and non-limiting. The scope of the present disclosure is defined by the appended claims rather than the above description. Therefore, all changes falling within the meanings and scope of equivalent elements of the claims are intended to be included in the present disclosure.

## Claims

1. A manufacturing process of a novel light-weight vacuum thermal insulation module, comprising the following steps:
step 1, preparation: selecting a macromolecular polymer as a wall material of the vacuum thermal insulation module, the macromolecular polymer being prepared by mixing polyether-ether-ketone, high-temperature nylon, a liquid crystal macromolecular polymer and polyphenylene sulfide, and stirring the macromolecular polymer with a heating and stirring hopper to achieve a liquid state;
step 2, molding: performing injection molding on the liquid-state macromolecular polymer by adopting an injection molding process to obtain a first wall surface and a second wall surface, the first wall surface and the second wall surface having mutually butted encapsulation surfaces, and forming a cavity between the first wall surface and the second wall surface after the encapsulated surfaces of the first wall surface and the second wall surface are butted;
step 3, setting of a getter: putting a getter into the cavity to further increase the vacuum degree of the final cavity and improve the thermal insulation efficiency;
step 4, vacuumizing by a vacuum pump: controlling an air extraction end of the vacuum pump to extend into the cavity along the encapsulation surfaces of the first wall surface and the second wall surface, the air extraction end being of a flat structure and overcoming, in a state of encapsulating and closing the first wall surface and the second wall surface, the stress of the macromolecular polymer material to enter the cavity to vacuumize the cavity; and
step 5, encapsulation: combining the encapsulation surfaces of the first wall surface and the second wall surface while vacuumizing, wherein the combination and the vacuumizing are synchronously performed; portions, not corresponding to the air extraction end of the vacuum pump, between the first wall surface and the second wall surface are first combined; the air extraction end is pulled out after the vacuumizing is completed, and under the action of an external atmospheric pressure, the first wall surface and the second wall surface promote portions, butted with the air extraction end, on the encapsulation surfaces to be closed; and the positions are then combined to form a vacuum thermal insulation module finished product.

2. The manufacturing process of the novel light-weight vacuum thermal insulation module according to claim 1, wherein the first wall surface is of an enclosed structure with a gap; the cavity is formed in the first wall surface; the second wall surface is of a sheet structure; the second wall surface is in encapsulation fit with the gap; and a position of the first wall surface located around the gap and a portion of the second wall surface corresponding to the position are used as the encapsulation surfaces.

3. The manufacturing process of the novel light-weight vacuum thermal insulation module according to claim 2, wherein after the getter is put in, the wall surface in the cavity is braced; and the cavity is filled with a low thermal conductivity multiporous core material to avoid collapse deformation of the material in the vacuumizing process.

4. The manufacturing process of the novel light-weight vacuum thermal insulation module according to claim 3, wherein the injection molding process of the first wall surface adopts a rubber coating injection molding process; during injection molding, the multiporous core material embedded with the getter is put into a mold, and rubber coating injection molding is performed on a surface of the multiporous core material; and after molding, the multiporous core material and the getter are directly located in the cavity.

5. The manufacturing process of the novel light-weight vacuum thermal insulation module according to claim 1, wherein after the first wall surface and the second wall surface have been subjected to injection molding, a polishing and coating process is performed on the first wall surface and the second wall surface: outer surfaces of the first wall surface and the second wall surface are polished, and the surfaces of the first wall surface and the second wall surface are coated with at least one layer of reflecting film.

6. The manufacturing process of the novel light-weight vacuum thermal insulation module according to claim 1, wherein the encapsulation surfaces of the first wall surface and the second wall surface are combined by an adhesion process; all adhesion surfaces are smeared with an adhesive; in the process, the vacuum pump is used to vacuumize the sealed cavity formed by the first wall surface and the second wall surface; and the air extraction end is pulled out after the adhesive is cured, thus preparing a vacuum thermal insulation module finished product.

7. The manufacturing process of the novel light-weight vacuum thermal insulation module according to claim 1, wherein the encapsulation surfaces of the first wall surface and the second wall surface are combined by a fusion process; a fixing jig with a heating structure is configured to locate and place the first wall surface and the second wall surface, so that the encapsulation surfaces of the first wall surface and the second wall surface are located at the heating structure, and fusion surfaces are formed on the encapsulation surfaces of the first wall surface and the second wall surface to achieve high-temperature molten fusion; in the fusion process, the vacuum pump is used to vacuumize the cavity formed between the first wall surface and the second wall surface; the fusion adhesion rate is controlled to be matched with the vacuumizing rate to ensure that fusion and vacuumizing end at the same time, thus preparing a vacuum thermal insulation module finished product.

8. The manufacturing process of the novel light-weight vacuum thermal insulation module according to claim 1, wherein the encapsulation surfaces of the first wall surface and the second wall surface are combined by an ultrasonic welding process; ultrasonic waves are applied to part of the encapsulation surfaces of the first wall surface and the second wall surface; in the process, the vacuum pump is used to vacuumize the cavity formed between the first wall surface and the second wall surface; the ultrasonic welding rate is controlled to be matched with the vacuumizing rate to ensure that fusion and vacuumizing end at the same time, thus preparing a vacuum thermal insulation module finished product.

9. A novel light-weight vacuum thermal insulation module, which adopts the vacuum thermal insulation module manufactured by the manufacturing process of a novel light-weight vacuum thermal insulation module according to claim 1, wherein the novel light-weight vacuum thermal insulation module comprises a first wall surface and a second wall surface; the first wall surface is of an enclosed structure with a gap, and the second wall surface is of a sheet structure; the second wall surface is in encapsulation fit with the gap, so that a vacuum cavity is formed between the first wall surface and the second wall surface; a position of the first wall surface located around the gap and a portion of the second wall surface corresponding to the position are provided with encapsulation surfaces; the first wall surface and the second wall surface are sealed by the encapsulation surfaces; the cavity is internally provided with a getter and is filled with a multiporous core material; one smooth layer is arranged on outer surfaces of the first wall surface and the second wall surface; and a layer of reflecting film is attached to the smooth layer.

10. The novel light-weight vacuum thermal insulation module according to claim 9, wherein one of an adhesive, a fusion surface or an ultrasonic welding surface is arranged between the encapsulation surfaces of the first wall surface and the second wall surface.
